# EUROPEAN PATENT SPECIFICATION

(11) **EP 3 226 499 B1**
(45) Date of publication and mention of the grant of the patent: **04.09.2019**
(21) Application number: 16163253.4
(22) Date of filing: 31.03.2016
(51) Int. Cl.: H04L 27/00, H03H 17/06

(54) **APPARATUSES AND METHODS FOR GENERATING A SECOND DIGITAL SIGNAL BASED ON A FIRST DIGITAL SIGNAL**
VORRICHTUNGEN UND VERFAHREN ZUR ERZEUGUNG EINES ZWEITEN DIGITALEN SIGNALS AUF BASIS EINES ERSTEN DIGITALEN SIGNALS
APPAREILS ET PROCÉDÉS POUR GÉNÉRER UN SECOND SIGNAL NUMÉRIQUE SUR LA BASE D'UN PREMIER SIGNAL NUMÉRIQUE

(43) Date of publication of application: 04.10.2017
(73) Proprietor: Intel IP Corporation, Santa Clara, CA 95054 (US)
(72) Inventor: Bode, Peter, 82008 München (DE); Horvat, Michael, 81737 München (DE); Menkhoff, Andreas, 82041 Oberhaching (DE); Scholand, Tobias, 47259 Duisburg (DE)
(74) Representative: 2SPL Patentanwälte PartG mbB

(56) References cited:
- US-A1- 2016 087 787
- US-B1- 6 584 145

## Description

### Field

Examples relate to sampling rate correction in digital signals. In particular, examples relate to apparatuses and methods for generating a second digital signal based on a first digital signal.

### Background

Document US 2016/0087787 A1 relates to a sample rate converter selecting sample positions of the output signal based on a ratio of an input sample rate to an output sample rate.

In document US 6,584,145 B1 it is referred to a sample rate converter for digital communication that controls the sample rate conversion based on the signal transmission rate.

For processing a finite data sequence in a digital signal (e.g. the data comprised by a slot of a Long Term Evolution, LTE, signal or a frame of an Orthogonal Frequency-Division Multiplexing, OFDM, signal), it may be necessary that samples corresponding to the finite data sequence are located at certain positions within the finite data sequence. For example, it may be required that a sample is located at the beginning or the end of an element (e.g. a symbol or a cyclic prefix) of the finite data sequence. For high sample rates, this may be achieved since the lengths of the elements of the finite data sequence are integer multiples of the corresponding sample period. However, for a lower sample rate, the lengths of the elements of the finite data sequence may be rational integers of the corresponding sample period. Accordingly, it may be impossible to sample the finite data sequence at the required positions with conventional sampling concepts.

Hence, there may be a desire to improve the sampling of a digital signal.

### Brief description of the Figures

Some examples of apparatuses and/or methods will be described in the following by way of example only, and with reference to the accompanying figures, in which
Fig. 1 illustrates an example of an apparatus for generating a second digital signal having a second sample rate based on a first digital signal having a first sample rate;
Fig. 2 illustrates an example of a structure of a LTE slot;
Fig. 3 illustrates a comparison of exemplary sample sequences of a section of the LTE slot illustrated in Fig. 2;
Fig. 4 illustrates an example of an apparatus for generating a second digital signal based on a first digital signal having a first sample rate;
Fig. 5 illustrates an example of a receiver comprising an apparatus for generating a second digital signal based on a first digital signal;
Fig. 6 illustrates an example of a receiver comprising two apparatuses for generating a second digital signal based on a first digital signal;
Fig. 7 illustrates another example of a receiver comprising two apparatuses for generating a second digital signal based on a first digital signal;
Fig. 8 illustrates an example of a transmitter comprising an apparatus for generating a second digital signal based on a first digital signal;
Fig. 9 illustrates an example of a mobile communications device comprising an apparatus for generating a second digital signal based on a first digital signal according to examples described herein;
Fig. 10 illustrates a flowchart of an example of a method for generating a second digital signal having a second sample rate based on a first digital signal having a first sample rate; and
Fig. 11 illustrates a flowchart of an example of a method for generating a second digital signal based on a first digital signal having a first sample rate.

### Detailed Description

Various examples will now be described more fully with reference to the accompanying drawings in which some examples are illustrated. In the figures, the thicknesses of lines, layers and/or regions may be exaggerated for clarity.

Accordingly, while further examples are capable of various modifications and alternative forms, some particular examples thereof are shown in the figures and will subsequently be described in detail. However, this detailed description does not limit further examples to the particular forms described. Further examples may cover all modifications, equivalents, and alternatives falling within the scope of the disclosure. Like numbers refer to like or similar elements throughout the description of the figures, which may be implemented identically or in modified form when compared to one another while providing for the same or a similar functionality.

It will be understood that when an element is referred to as being "connected" or "coupled" to another element, the elements may be directly connected or coupled or via one or more intervening elements. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent", to name just a few examples).

The terminology used herein is for the purpose of describing particular examples is not intended to be limiting for further examples. Whenever a singular form such as "a," "an" and "the" is used and using only a single element is neither explicitly or implicitly defined as being mandatory, further examples may also use plural elements to implement the same functionality. Likewise, when a functionality is subsequently described as being implemented using multiple elements, further examples may implement the same functionality using a single element or processing entity. It will be further understood that the terms "comprises," "comprising," "includes" and/or "including," when used, specify the presence of the stated features, integers, steps, operations, processes, acts, elements and/or components, but do not preclude the presence or addition of one or more other features, integers, steps, operations, processes, acts, elements, components and/or any group thereof.

Unless otherwise defined, all terms (including technical and scientific terms) are used herein in their ordinary meaning of the art to which the examples belong, unless expressly defined otherwise herein.

In the following, various examples relate to devices (e.g. cell phone, base station) or components (e.g. transmitter, transceiver) of devices used in wireless or mobile communications systems. A mobile communication system may, for example, correspond to one of the mobile communication systems standardized by the 3rd Generation Partnership Project (3GPP), e.g. Global System for Mobile Communications (GSM), Enhanced Data rates for GSM Evolution (EDGE), GSM EDGE Radio Access Network (GERAN), High Speed Packet Access (HSPA), Universal Terrestrial Radio Access Network (UTRAN) or Evolved UTRAN (E-UTRAN), LTE or LTE-Advanced (LTE-A), or mobile communication systems with different standards, e.g. Worldwide Interoperability for Microwave Access (WIMAX) IEEE 802.16 or Wireless Local Area Network (WLAN) IEEE 802.11, generally any system based on Time Division Multiple Access (TDMA), Frequency Division Multiple Access (FDMA), Orthogonal Frequency Division Multiple Access (OFDMA), Code Division Multiple Access (CDMA), etc. The terms mobile communication system and mobile communication network may be used synonymously.

The mobile communication system may comprise a plurality of transmission points or base station transceivers operable to communicate radio signals with a mobile transceiver. In these examples, the mobile communication system may comprise mobile transceivers, relay station transceivers and base station transceivers. The relay station transceivers and base station transceivers can be composed of one or more central units and one or more remote units.

A mobile transceiver or mobile device may correspond to a smartphone, a cell phone, User Equipment (UE), a laptop, a notebook, a personal computer, a Personal Digital Assistant (PDA), a Universal Serial Bus (USB) -stick, a tablet computer, a car, etc. A mobile transceiver or terminal may also be referred to as UE or user in line with the 3GPP terminology. A base station transceiver can be located in the fixed or stationary part of the network or system. A base station transceiver may correspond to a remote radio head, a transmission point, an access point, a macro cell, a small cell, a micro cell, a pico cell, a femto cell, a metro cell etc. The term small cell may refer to any cell smaller than a macro cell, i.e. a micro cell, a pico cell, a femto cell, or a metro cell. Moreover, a femto cell is considered smaller than a pico cell, which is considered smaller than a micro cell. A base station transceiver can be a wireless interface of a wired network, which enables transmission and reception of radio signals to a UE, mobile transceiver or relay transceiver. Such a radio signal may comply with radio signals as, for example, standardized by 3GPP or, generally, in line with one or more of the above listed systems. Thus, a base station transceiver may correspond to a NodeB, an eNodeB, a BTS, an access point, etc. A relay station transceiver may correspond to an intermediate network node in the communication path between a base station transceiver and a mobile station transceiver. A relay station transceiver may forward a signal received from a mobile transceiver to a base station transceiver, signals received from the base station transceiver to the mobile station transceiver, respectively.

The mobile communication system may be cellular. The term cell refers to a coverage area of radio services provided by a transmission point, a remote unit, a remote head, a remote radio head, a base station transceiver, relay transceiver or a NodeB, an eNodeB, respectively. The terms cell and base station transceiver may be used synonymously. In some examples a cell may correspond to a sector. For example, sectors can be achieved using sector antennas, which provide a characteristic for covering an angular section around a base station transceiver or remote unit. In some examples, a base station transceiver or remote unit may, for example, operate three or six cells covering sectors of 120° (in case of three cells), 60° (in case of six cells) respectively. Likewise a relay transceiver may establish one or more cells in its coverage area. A mobile transceiver can be registered or associated with at least one cell, i.e. it can be associated to a cell such that data can be exchanged between the network and the mobile in the coverage area of the associated cell using a dedicated channel, link or connection. A mobile transceiver may hence register or be associated with a relay station or base station transceiver directly or indirectly, where an indirect registration or association may be through one or more relay transceivers.

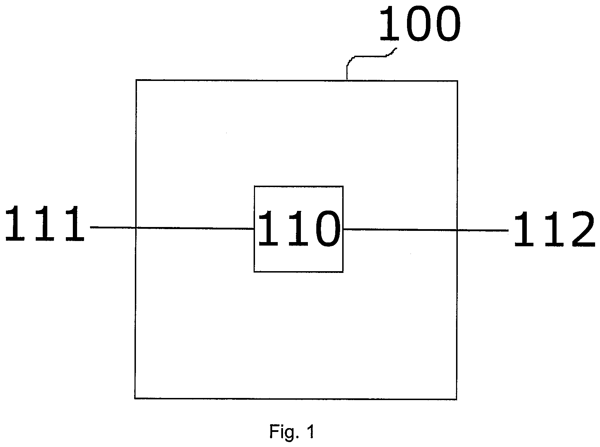

**Fig. 1** illustrates an example of an apparatus 100 for generating a second digital signal 112 having a second sample rate based on a first digital signal 111 having a first sample rate. The first digital signal 111 represents a finite data sequence. That is, the finite data sequence comprises a finite number of elements (e.g. bits, symbols, cyclic prefixes, samples). Moreover, the temporal expansion of the finite data sequence is finite. For example, the finite data sequence may be the data comprised by a frame of a LTE signal, a sub-frame of a LTE signal, a slot of a LTE signal, a frame of an OFDM signal, or a sub-frame of an OFDM signal. However, the finite data sequence is not limited to data structures of signals used in mobile communications applications. The first digital signal may, in general, be any signal representing a finite data sequence.

The apparatus 100 comprises a sample rate converter 110 for converting the first sample rate of the first digital signal 111 to the second sample rate of the second digital signal. The first sample rate may be equal to the second sample rate or may be different from the second sample rate. For example, the first sample rate may be lower than the second sample rate or vice versa. The ratio between the first sample and the second sample rate, which is also called sample rate conversion factor, may be an integer number or a non-integer number. That is, the sample rate converter 110 may in some examples be a fractional sample rate converter.

The sample rate converter 110 resamples the first digital signal 111 at a compensated sample time as a sample of the second digital signal 112. That is, the sample rate converter 110 resamples the first digital signal 111 at the compensated sample in order to generate (calculate) the sample of the second digital signal 112. For example, for calculating the sample of the second digital signal 112, the sample rate converter 110 may interpolate samples of the first digital signal 111.

A time interval between a sample time of the first digital signal 111 and the compensated sample time is modified based on a structure of the finite data sequence. Accordingly, a phase of the sample of the second digital signal 112 may be adjusted to a desired position (location) within the finite data sequence. That is, the finite data sequence may be sampled globally with the second sample rate, whereas the phase position of one or more individual samples may be adjusted to the structure of the finite data sequence.

For example, if the structure of the finite data sequence is known, the time interval may be modified such that the sample of the second digital signal is located at a desired (required) position within the finite data sequence. If the finite sequence is, e.g., the data comprised by a LTE slot, the time interval may be modified such that sample of the second digital signal 112 is located at the beginning of an element (e.g. a symbol or a cyclic prefix) of the LTE slot.

For example, the sample rate converter 110 may set the time interval to the difference between the sample time of the first digital signal 111 and the time instant of the beginning of an element of the data structure in the first digital signal 111. Hence, the compensated sample time of the sample of the second digital signal 112 is equal to the time instant of the beginning of an element of the data structure in the first digital signal 111. In other words, the sample of second digital signal 112 corresponds to the beginning of the element of the finite data structure.

In some examples, the sample rate converter 110 may comprise a plurality of sets of coefficients. The plurality of sets of coefficients may, e.g., be stored in a memory of the sample rate converter 110, or an external memory the sample rate converter is able to access. In these examples, the sample rate converter 110 calculates the sample of the second digital signal 112 using one of the plurality of sets of coefficients, wherein the one of the plurality of sets of coefficients is selected based on the structure of the finite data sequence. For calculating the sample of the second digital signal 112, the sample rate converter may, e.g., combine the one of the plurality of sets of coefficients and one ore more samples of the first digital signal 111. The combination may be linear or non-linear. The sample rate converter 110 may, hence, be considered as a Finite Impulse Response (FIR) filter using one of the plurality of sets of coefficients as filter coefficients. The sets of coefficients may be selected such that different sets of coefficients relate to different time delays. Hence, a set of coefficients may be called "polyphase". Accordingly, the compensated sample time may be adjusted by selecting a corresponding polyphaser, i.e., a corresponding set of coefficients.

The one of the plurality of sets of coefficients is in some examples further selected based on a comparison of the first sample rate and the second sample rate. Accordingly, the one set of coefficients may be further selected according to the relation between the first and the second sample rate. Hence, the one set of coefficients may be selected not only based on a desired sample time but also on the relation between the first and the second sample rate.

The apparatus may comprise one or more additional optional features corresponding to one or more aspects of the proposed concept or one or more examples described below. Generally speaking, some examples of the proposed concept relate to a means for generating a second digital signal having a second sample rate based on a first digital signal having a first sample rate, wherein the first digital signal represents a finite data sequence. The means comprises a means for resampling the first digital signal at a compensated sample time as a sample of the second digital signal, wherein the means for resampling the first digital signal is configured to modify a time interval between a sample time of the first digital signal and the compensated sample time based on a structure of the finite data sequence.

In some examples, the means for resampling the first digital signal may be configured to set the time interval to the difference between the sample time of the first digital signal and the time instant of the beginning of an element of the data structure in the first digital signal.

The means for generating a second digital signal having a second sample rate based on a first digital signal having a first sample rate may be implemented by an apparatus for generating a second digital signal having a second sample rate based on a first digital signal having a first sample rate described above or below (e.g. Fig. 1). The means for resampling the first digital signal may be implemented by a sample rate converter described above or below (e.g. Fig. 1).

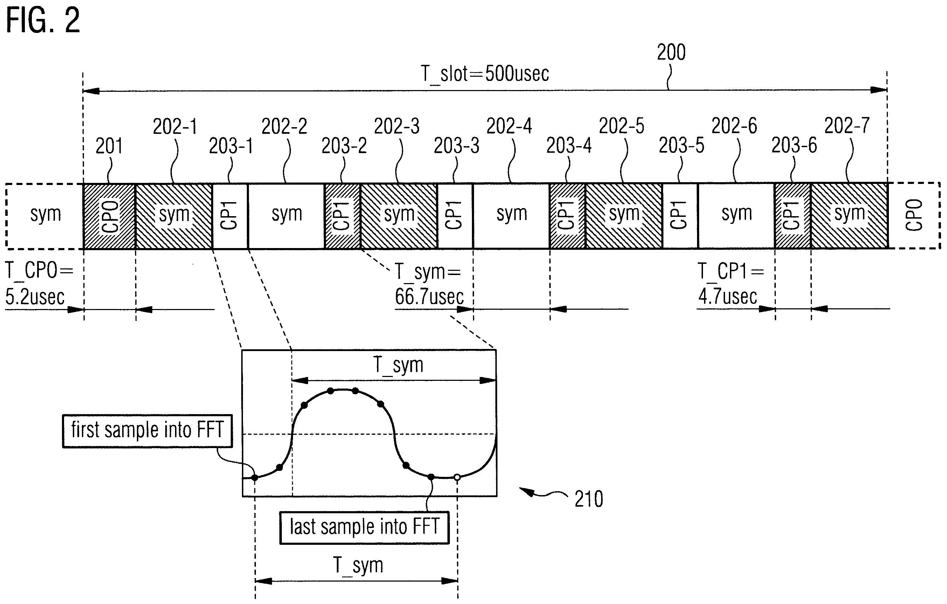

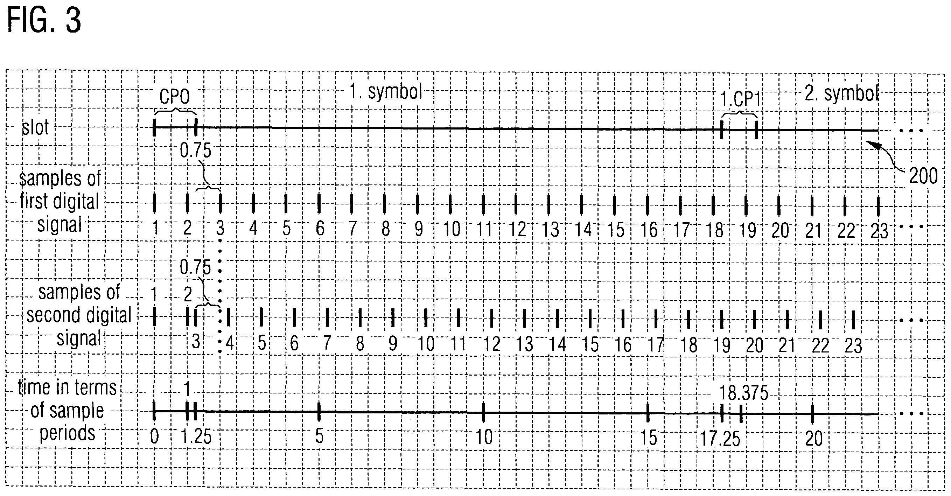

An application scenario for the proposed concept is illustrated in Figs. 2 and 3. Fig. 2 illustrates the structure of a LTE slot 200 as an example for a finite data structure. The LTE slot has a duration of 500 µsec.

The LTE slot 200 begins with a first cyclic prefix (CP0) 201 having a first length of 5.2 µsec. The first cyclic prefix 201 is succeeded by seven symbols 202-1, ..., 202-7 having a length of 66.7 µsec, respectively, which are separated by respective second cyclic prefixes (CP1) 203-1, ..., 203-6 having a second length of 4.7 µsec.

For illustrative purposes, box 210 of Fig. 2 further indicates potential baseband processing (Fast Fourier Transformation, FFT) of samples of the cyclic prefix 203-1 and the succeeding symbol 202-2, in case the LTE slot 200 is part of a LTE receive signal.

In the frequency domain, 6 resource blocks a 12 sub carriers are allocated to a legacy LTE 1.4 signal (i.e. an LTE signal with a channel bandwidth of 1.4 MHz). The sub carrier spacing is 15 kHz. That is, 6 12 + 1 = 73 sub carriers are allocated to the signal, which corresponds to an occupied bandwidth of 73·15 kHz = 1095 kHz.

For Internet of Things (IoT) applications, Narrow Band LTE (NB-LTE) is used for transmitting small data packets at narrow frequency bands. For a NB-LTE signal, 1 resource block a 12 sub carriers is allocated - corresponding to an occupied bandwidth of 13 • 15 kHz = 195 kHz.

In order to save power, it is desired to provide the NB-LTE signal (in-phase & quadrature component) at a low sample rate of 240 kHz to the baseband processing modules. As a comparison, the LTE 1.4 signal is provided at a sample of 1.92 MHz to the baseband processing modules. An overview of baseband sample rates (f samp) for LTE signals of different bandwidths is given in table 1. The columns NB-LTE 1 and NB-LTE 2 denote non-standardized LTE signals having a baseband sample rate of 480 kHz and 960 kHz, respectively.

**Table 1: Overview of baseband sample rates**

| | LTE 20 | LTE 10 | LTE 5 | LTE 3 | LTE 1.4 | NB-LTE 2 | NB-LTE 1 | NB-LTE |
|---|---|---|---|---|---|---|---|---|
| f_samp [MHz] | 30.72 | 15.36 | 7.68 | 3.84 | 1.92 | 0.96 | 0.48 | 0.24 |
| 30.72 MHz / f_samp | 1 | 2 | 4 | 8 | 16 | 32 | 64 | 128 |

Further, table 2 gives an overview of the lengths of the cyclic prefixes (CP0, CP1) and symbols in a LTE slot in terms of the respective sample periods of the different LTE signals.

**Table 2: Overview of lengths**

| | LTE 20 | LTE 10 | LTE 5 | LTE 3 | LTE 1.4 | NB-LTE 2 | NB-LTE 1 | NB-LTE | length [µsec] |
|---|---|---|---|---|---|---|---|---|---|
| CP0 | 160 | 80 | 40 | 20 | 10 | 5 | 2.5 | 1.25 | 5.21 |
| CP1 | 144 | 72 | 36 | 18 | 9 | 4.5 | 2.25 | 1.125 | 4.69 |
| symbol | 2048 | 1024 | 512 | 256 | 128 | 64 | 32 | 16 | 66.67 |

Table 3 gives an overview on the starting positions of the 7 (OFDM) symbols and the cyclic prefixes in the LTE slot illustrated in Fig. 2 in terms of respective sample periods.

**Table 3: Overview of starting positions within the LTE slot**

| | LTE 20 | LTE 10 | LTE 5 | LTE 3 | LTE 1.4 | NB-LTE 2 | NB-LTE 1 | NB-LTE | time [µsec] |
|---|---|---|---|---|---|---|---|---|---|
| CP0 | 0 | 0 | 0 | 0 | 0 | 0 | 0 | 0 | 0 |
| 1. symbol | 160 | 80 | 40 | 20 | 10 | 5 | 2.5 | 1.25 | 5.21 |
| 1. CP1 | 2208 | 1104 | 552 | 276 | 138 | 69 | 34.5 | 17.25 | 71.88 |
| 2. symbol | 2352 | 1176 | 588 | 294 | 147 | 73.5 | 36.75 | 18.375 | 76.56 |
| 2. CP1 | 4400 | 2200 | 1100 | 550 | 275 | 137.5 | 68.75 | 34.375 | 143.23 |
| 3. symbol | 4544 | 2272 | 1136 | 568 | 284 | 142 | 71 | 35.5 | 147.92 |
| 3. CP1 | 6592 | 3296 | 1648 | 824 | 412 | 206 | 103 | 51.5 | 214.58 |
| 4. symbol | 6736 | 3368 | 1684 | 842 | 421 | 210.5 | 105.25 | 52.625 | 219.27 |
| 4. CP1 | 8784 | 4392 | 2196 | 1098 | 549 | 274.5 | 137.25 | 68.625 | 285.04 |
| 5. symbol | 8928 | 4464 | 2232 | 1116 | 558 | 279 | 139.5 | 69.75 | 290.63 |
| 5. CP1 | 10976 | 5488 | 2744 | 1372 | 686 | 343 | 171.5 | 85.75 | 357.29 |
| 6. symbol | 11120 | 5560 | 2780 | 1390 | 695 | 347.5 | 173.75 | 86.875 | 361.98 |
| 6. CP1 | 13168 | 6584 | 3292 | 1646 | 823 | 411.5 | 205.75 | 102.875 | 428.65 |
| 7. symbol | 13312 | 6656 | 3328 | 1664 | 832 | 416 | 208 | 104 | 433.33 |
| end slot | 15360 | 7680 | 3840 | 1920 | 960 | 480 | 240 | 120 | 500 |

It is evident from table 2 that the length of the cyclic prefixes in terms of the sample period is not an integer value for NB-LTE. Moreover, it is evident from table 3 that the starting positions of the symbols and the cyclic prefixes are not integer values of the sample period for NB-LTE. In other words, conventional cyclic prefix removal does not fit to the sample grid any more. However, for performance reasons, it is desirable (required) that the timing of conventional cyclic prefix removal is used. If cyclic prefix removal was rounded to the integer sample grid at 240 kHz baseband sample rate, delay spread robustness would be reduced greatly. Moreover, since two types of cyclic prefixes with different lengths are used in a LTE slot, the cyclic prefix removal timing error per (OFDM) symbol is variable. Hence, the corresponding (OFDM) symbol specific rotation after FFT in the baseband would spoil pilot tracking and decoding.

In order to enable conventional cyclic prefix removal, the apparatus 100 as illustrated in Fig. 1 may be used in order to adjust the phases of the samples in the LTE slot. Accordingly, the phases of the individual samples may be adjusted such that the samples that are passed to the further base band processing (e.g. FFT) have the desired timing. As is evident from tables 2 and 3, a resolution of 1/8 sample period is required in order to avoid cyclic prefix removal timing errors.

The sample adjustment may become more evident from **Fig.3****,** which illustrates a comparison of exemplary sample sequences of a section of the LTE slot 200 illustrated in Fig. 2.

The illustrated section of the LTE slot 200 is the beginning of the LTE slot 200. As described above, the LTE slot 200 begins with a first cyclic prefix CP0 having a first length. The first cyclic prefix CP0 is succeeded by the first symbol, which itself is succeeded by a second cyclic prefix CP1 having a second length. In the LTE slot 200, the second cyclic prefix is succeeded by the second to seventh symbols, which are separated by further cyclic prefixes of the second length.

In the example illustrated in Fig. 3, it is assumed that the first sample rate of the first digital signal, which represents the data comprised by the LTE slot 200, is equal to the second sample rate of the second digital signal. According to examples, the second sample rate may be lower than 1.92 MHz. In particular, the second sample rate may be 240 kHz as illustrated in the example of Fig. 3.

The data comprised by the LTE slot 200 is an example for a finite data structure, which is represented by the first digital signal. The first digital signal may, e.g., be related to a LTE receive signal. For example, the first digital signal may be provided on the basis of a down-mixed LTE receive signal. Accordingly, the first symbol is an example for an element of the finite data sequence (= LTE slot 200).

As indicated already in table 3, the time instant of the beginning of the first symbol in the first digital signal is 1.25 sample periods after the beginning of the LTE slot 200. In the first digital signal, no sample is located at this time instant. There is merely sample 2, which is located 1 sample period after the beginning of the LTE slot 200, and sample 3, which is located 2 sample periods after the beginning of the LTE slot 200. Since no sample is located at the beginning of the first symbol, the first digital signal cannot be processed (e.g. FFT) using conventional baseband processing methods or algorithms as described above. However, using the a priori knowledge of the LTE slot's structure, the apparatus 100 may be used to modify the phase of samples within the second digital signal such that a sample is located at the beginning of the first symbol. For example, the sample rate converter 110 may set time interval between the sample time of sample 3 in the first digital signal and the compensated sample time of sample 3 in the second digital signal to the difference between the sample time of sample 3 in the first digital signal and the time instant of the beginning of the first symbol in the first digital signal, i.e., set the time interval to 0.75 sample periods. Accordingly, the compensated sample time of sample 3 of the second digital signal corresponds the time instant of the beginning of the first symbol.

The respective time intervals between the sample times of samples 4, 5, 6, ..., 19 in the first digital signal and the compensated sample times of samples 4, 5, 6, ..., 19 in the second digital signal may be set likewise. Hence, sample 19 of the second digital signal is located at the beginning of the second prefix CP1 at 17.25 sample periods. That is, 16 samples are provided for the first symbol as required for the subsequent baseband processing.

The second symbol begins after 18.375 sample periods. In order to sample the second symbol as required, the sample rate converter 110 may set the time interval between the sample time of sample 20 in the first digital signal and the compensated sample time of sample 20 in the second digital signal to the difference between the sample time of sample 20 in the first digital signal and the time instant of the beginning of the second symbol in the first digital signal, i.e., set the time interval to 0.625 sample periods. Sample 20 of the first digital signal is located at 18.375 sample periods. Accordingly, the compensated sample time of sample 20 of the second digital signal corresponds the time instant of the beginning of the second symbol. The respective time intervals between the sample times of samples 21, 22, 23, ... in the first digital signal and the compensated sample times of samples 21, 22, 23, ... in the second digital signal may be set likewise.

Hence, the LTE slot 200 may be sampled with a global constant sample rate by adjusting the phase of one or more of the samples. That is, an LTE slot may be resampled with a defined number of samples (e.g. 120 samples per slot for NB-LTE, which corresponds to a sample rate of 240 kHz), but the phases between succeeding samples within the slot vary.

For calculating the samples, the sample rate converter may use different sets of coefficients. As explained with respect to Fig. 1, different sets of coefficients may relate to different time delays. Accordingly, a first set of coefficients may, e.g., be used for calculating samples 1 and 2 in the example of Fig. 3, whereas a different second set of coefficients may be used for calculating samples 3 to 19, a different third set of coefficients may be used for calculating samples 20 to 36, and so on. Since the structure of the LTE slot 200 is a priori known, a defined sequence of sets of coefficients may be used by the sample rate converter 110. In other words, a defined sequence of polyphases may be used for resampling the first digital signal. For a LTE slot comprising seven (OFDM) symbols, the sequence of polyphases may, e.g., be repeated periodically every seven (OFDM) symbols. Hence, succeeding LTE slots may sampled such that the second digital signal may be used for conventional baseband processing.

In the example of Fig. 3, it was assumed that the first sample rate of the first digital signal is equal to the second sample rate of the second digital signal. However, the proposed concept is not limited thereto. In some examples, the second sample may be lower than the first sample rate. Accordingly, the apparatus 100 may then be further used to adjust the sample rate, or to correct for sample rate errors. For example, 8 polyphases (i.e. 8 sets of coefficients providing a phase shift resolution of 1/8 sample period) may be sufficient for sampling the LTE slot 200 with 240 kHz sample rate as illustrated in Fig. 2. In order to correct the sample rate, i.e., to correct for sample rate errors, about 64 polyphases may be used for a 240 kHz sample rate in some examples.

The examples of Figs. 2 and 3 discussed examples, where the first digital signal was related to a LTE receive signal. In other words, the application of the proposed concept in a receiver was discussed. However, the proposed concept is not limited thereto. The proposed concept may be used vice versa in a transmitter. For example, it may be required to shorten or extend signal segments by fractional samples. The first digital signal may, e.g., be related to a LTE baseband transmit signal and the finite data sequence may be the data comprised by a slot of the LTE baseband transmit signal. Accordingly, the apparatus 100 may be used to shift one or more samples of the second digital signal such that the samples are located at a desired position within the LTE slot (e.g. at the beginning of a symbol within the slot). For example, for IoT applications, the first sample rate of the first digital signal (which is related to the LTE baseband transmit signal) may be lower than 1.92 MHz. In some examples, the first sample rate may be 240 kHz (e.g. for NB-LTE).

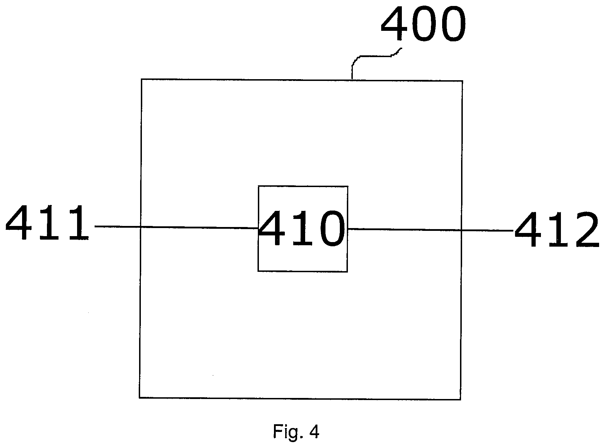

Another example of the proposed concept is illustrated in Fig. 4. Fig. 4 illustrates an example of an apparatus 400 for generating a second digital signal 412 based on a first digital signal 411 having a first sample rate. Again, the first digital signal 411 represents a finite data sequence.

The apparatus 400 comprises a sample rate converter 410. The sample rate converter 410 may in some examples be a fractional sample rate converter. The sample rate converter 410 calculates a first series of samples of the second digital signal 412 and a second series of samples of the second digital signal 412 based on the first digital signal 411. The second series of samples directly succeeds the first series of samples, wherein succeeding samples within the first series of samples and succeeding samples within the second series of samples are separated by a first phase, respectively. That is, the time interval between succeeding samples within the first series and the second series is constant.

The sample rate converter 410 modifies a second phase between a last sample of the first series of samples and a first sample of the second series of samples based on a structure of the finite data sequence, wherein the second phase is different from the first phase.

Accordingly, the second phase may be adjusted such that the first series and the second series of samples are at desired (required) positions within the finite data sequence. That is, the finite data sequence may be sampled globally with a constant second sample rate (corresponding to the first phase), whereas the phase between individual series of samples may be adjusted to the structure of the finite data sequence.

Regarding the example of Fig. 3, the first series of samples of the second digital signal corresponds to samples 1 and 2 of the second digital signal, whereas the second series of samples corresponds to samples 3 to 19 of the second digital. Samples 1 and 2, as well as samples 3 and 4, 4 and 5, ..., 18 and 19 are separated by a common first phase (here one sample period at 240 kHz sample rate). However, sample 2 and 3 are separated by a second phase (here 1/4 sample period at 240 kHz sample rate), which is different from the first phase. That is, the time difference between the second phase and the first phase is an integer fraction of the first phase. Hence, the apparatus 400 may allow to provide the second signal with the required distribution of the samples for the further (baseband) processing.

For achieving the required resampling of the first digital signal, the sample rate converter 410 may, e.g., set the second phase to the difference between a duration of a first element of the finite data sequence and a time interval between the first and the last sample of the first series of samples. Regarding the example of Fig. 3, the finite data sequence is again the data comprised by the LTE slot 200. The first element is the first cyclic prefix CP0. The first cyclic prefix CP0 has a duration (length) of 1.25 sample periods. The time interval between sample 1 and sample 2 of the second digital signal is one sample period. Hence, the sample rate converter sets the second phase to 0.25 sample periods. As a consequence, the second series of samples begins at the beginning of the first symbol, so that the second digital signal may be used for conventional baseband processing (e.g. cyclic prefix removal, FFT).

Likewise, the sample rate converter 410 may calculate a third series of samples of the second digital signal, wherein the third series of samples directly succeeds the second series of samples. Succeeding samples within the third series of samples are again separated by the first phase, respectively. The sample rate converter modifies a third phase between a last sample of the second series of samples and a first sample of the third series of samples based on the structure of the finite data sequence, wherein the third phase is different from the first phase.

Regarding the example of Fig. 3, the third series of samples of the second digital signal corresponds to samples 20 to 36 of the second digital signal, which are separated by the common first phase (here one sample period at 240 kHz sample rate). Samples 20 to 36 represent the second symbol. However, sample 19 of the second series of samples and sample 20 of the third series of samples are separated by the third phase (here 9/8 sample period at 240 kHz sample rate), which is different from the first phase.

The sample rate converter 410 may, e.g., set the third phase to the difference between a duration of a second element of the finite data sequence and a time interval between the first and the last sample of the second series of samples. Regarding the example of Fig. 3, the second element is (the combination of) the first symbol and the succeeding second cyclic prefix CP1. The first symbol has a duration of 16 sample periods and the second cyclic prefix CP1 has a duration of 1.125 sample periods, so that the second element has a total duration of 17.125 sample periods. The time interval between sample 3 and sample 19 of the second digital signal is 16 sample periods. Hence, the sample rate converter sets the third phase to 1.125 sample periods. As a consequence, the third series of samples begins at the beginning of the second symbol, so that the second digital signal may be used for conventional baseband processing (e.g. cyclic prefix removal, FFT).

In the example of Fig. 3, the first sample rate of the first digital signal corresponds to the first phase. That is, the first phase is equal to a sample period corresponding to the first sample rate (here 240 kHz). In other words, the global second sample rate of the second digital signal is equal to the first sample rate of the first digital signal. However, the proposed concept is not limited thereto. The first phase may alternatively be different from the sample period corresponding to the first sample rate. That is, the global second sample rate of the second digital signal may be different from the first sample rate of the first digital signal

For the first digital signal being related to a LTE receive signal and the finite data sequence being the data comprised by a slot of the LTE receive signal, the first phase may be greater than 0.521 microseconds (corresponding to a sample rate of 1.92 MHz). In some examples, the first phase may correspond to a sample rate of 240 kHz.

However, the proposed concept is not limited to the first digital signal being related to a LTE receive signal. The first digital signal may alternatively, e.g., be related to a LTE baseband transmit signal and the finite data sequence may be the data comprised by a slot of the LTE baseband transmit signal. Accordingly, the apparatus 400 may be used to shift samples of the second digital signal such that the samples are located at a desired position within the LTE slot. For example, for IoT applications, the first sample rate of the first digital signal (which is related to the LTE baseband transmit signal) may be lower than 1.92 MHz. In some examples, the first sample rate may be 240 kHz (e.g. for NB-LTE). In general, the first digital signal may be any digital signal representing a finite data sequence. The finite data sequence is not limited to data structures of signals used in mobile communications applications.

Hence, the LTE slot 200 may be sampled with a global constant sample rate by adjusting the phase between succeeding series of samples. That is, an LTE slot may be resampled with a defined number of samples (e.g. 120 samples per slot for NB-LTE, which corresponds to a sample rate of 240 kHz), but the phases between succeeding series of (equally spaced) samples within the slot vary.

In some examples, the sample rate converter 410 may comprise a plurality of sets of coefficients. The plurality of sets of coefficients may, e.g., be stored in a memory of the sample rate converter 410, or an external memory the sample rate converter is able to access. In these examples, the sample rate converter 410 calculates the first series of samples of the second digital signal using a first set of the plurality of sets of coefficients, and calculates the second series of samples of the second digital signal using a second set of the plurality of sets of coefficients. The second set of the plurality of sets of coefficients is different from the first set of the plurality of sets of coefficients. The first set and the second set are selected based on the structure of the finite data sequence. For calculating the samples of the second digital signal 412, the sample rate converter may, e.g., combine the respective one of the plurality of sets of coefficients and one or more samples of the first digital signal 411. The combination may be linear or non-linear. The sample rate converter 410 may, hence, be considered as a FIR filter using the plurality of sets of coefficients as filter coefficients. The sets of coefficients may be selected such that different sets of coefficients relate to different time delays, i.e., a set of coefficients represents a "polyphase".

Regarding the example of Fig. 3, a first set of coefficients may, e.g., be used for calculating samples 1 and 2 in the example of Fig. 3, whereas a different second set of coefficients may be used for calculating samples 3 to 19, a different third set of coefficients may be used for calculating samples 20 to 36, and so on. Since the structure of the LTE slot 200 is a priori known, a defined sequence of sets of coefficients may be used by the sample rate converter 410. In other words, a defined sequence of polyphases may be used for resampling the first digital signal. For a LTE slot comprising seven (OFDM) symbols, the sequence of polyphases may, e.g., be repeated periodically every seven (OFDM) symbols. Hence, succeeding LTE slots may sampled such that the second digital signal may be used for, e.g., conventional baseband processing.

At least one of the first set and the second set may in some examples be further selected based on a comparison of the first sample rate and the first phase. Accordingly, the one set of coefficients may be further selected according to the relation between the sample rate of the first digital signal and the global sample rate of the second digital signal. Hence, the one set of coefficients may be selected not only based on a desired sample time but also on the relation between the sample rates of the digital signals.

The apparatus may comprise one or more additional optional features corresponding to one or more aspects of the proposed concept or one or more examples described below.

Generally speaking, some examples of the proposed concept relate to a means for generating a second digital signal based on a first digital signal having a first sample rate, wherein the first digital signal represents a finite data sequence. The means comprises a means for calculating a first series of samples of the second digital signal and a second series of samples of the second digital signal based on the first digital signal, wherein the second series of samples directly succeeding the first series of samples. Succeeding samples within the first series of samples and succeeding samples within the second series of samples are separated by a first phase, respectively. The means for calculating is configured to modify a second phase between a last sample of the first series of samples and a first sample of the second series of samples based on a structure of the finite data sequence, wherein the second phase is different from the first phase.

In some examples, the means for calculating is configured to set the second phase to the difference between a duration of a first element of the finite data sequence and a time interval between the first and the last sample of the first series of samples.

The means for generating a second digital signal based on a first digital signal having a first sample rate may be implemented by an apparatus for generating a second digital based on a first digital signal having a first sample rate described above or below (e.g. Fig. 4). The means for calculating may be implemented by a sample rate converter described above or below (e.g. Fig. 4).

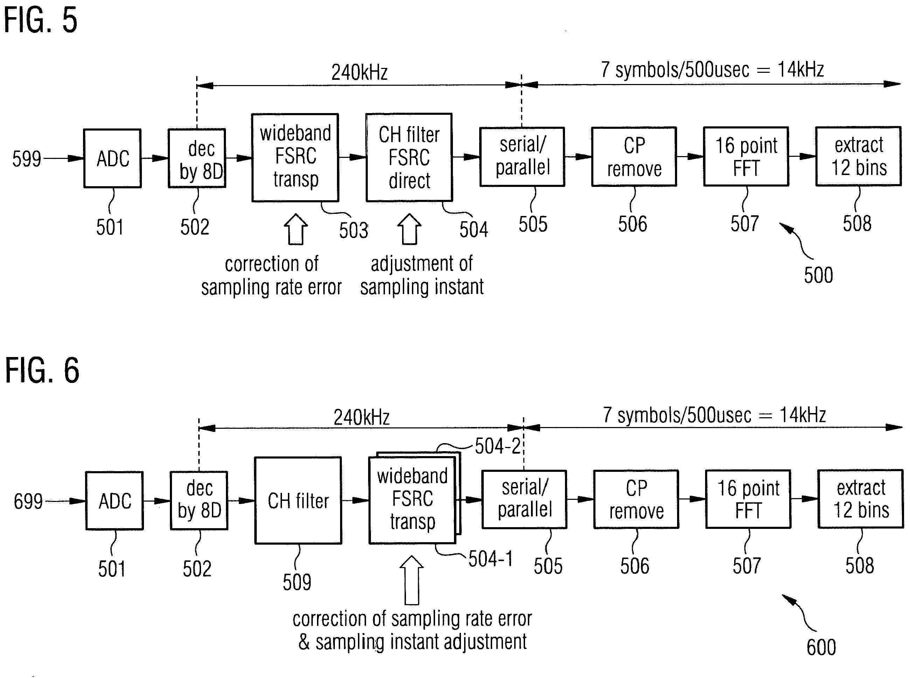

Examples of implementations using one or more apparatuses for generating a second digital signal based on a first digital signal according to one or more aspects of the proposed concept or one or more examples described above are illustrated in Figs. 5 to 8.

Fig. 5 illustrates a NB-LTE receiver 500. The receiver 500 comprises an analog-to-digital converter (ADC) 501, which receives an analog LTE receive signal 599 and supplies a digital output signal to a decimation module 502. The decimation module 502 decimates the digital output signal and supplies the decimated output signal to a (fractional) sample rate converter 503. For example, the decimation module 502 module may provide the decimated output signal at a sample rate of substantially 240 kHz. In order to correct for sample rate errors, the sample rate converter 503 is used. The sample rate converter 503 generates, based on the decimated output signal of the ADC, the first digital signal for an apparatus 504 for generating a second digital signal based on a first digital signal according to one or more aspects of the proposed concept or one or more examples described above. That is, the sample rate converter 503 ensures that the first digital signal for the apparatus 504 has the desired sample rate of 240 kHz for baseband processing. The apparatus 504 generates a second digital signal at a sample rate of 240 kHz and adjusts the phases of one or more samples of the second digital signal according to the structure of slot of the LTE receive signal 799, which is represented by the first digital signal, as described above. For selecting the correct polyphase, a finite state machine or firmware may be used for a low number of selectable polyphases (e.g. 8 selectable polyphases). Alternatively, a numerically controlled oscillator may be used for a higher number of selectable polyphases (e.g. 64 selectable polyphases).

The second digital signal is supplied to serial to parallel converter 505 and from there to a cyclic prefix removal module 506, which removes the cyclic prefixes from the signal. The prefix-free signal is then supplied to a FFT module 507, which applies a 16 point Fourier transformation to the signal. From the result of the Fourier transformation, 4 bins are discarded. That is, an extraction module 508 extracts 12 bins, which are further baseband processed. The serial to parallel converter 505, the cyclic prefix removal module 506a, the FFT module 507, and the extraction module 508 may be implemented by a single baseband processing unit (e.g. a baseband processor).

In summary, Fig. 5 illustrates a receiver comprising an apparatus 504 for generating a second digital signal based on a first digital signal according to one or more aspects of the proposed concept or one or more examples described above, and a second sample rate converter 503 configured to generate the first digital signal based on a decimated output signal of an ADC 501.

The apparatus 504 of NB-LTE receiver 500 may allow to provide the IQ signal to the baseband at a sample rate of 240 kHz, so that conventional cyclic prefix removal may be used. Moreover, the individual (OFDM) symbols have the desired (required) timing for the FFT.

An alternative implementation of the receiver 500 of Fig. 5 is illustrated in Fig. 6. In contrast to the receiver 500, the receiver 600 illustrated in Fig. 6 does not comprise a sample rate converter for ensuring that the first digital signal is supplied to the apparatus 504 at the sample rate as sample rate of the second digital signal, which is output by the apparatus 504. Instead, the receiver 600 comprises in addition to the first apparatus 504-1 a second apparatus 504-2 for generating a second digital signal according to one or more aspects of the proposed concept or one or more examples described above, which is connected in parallel to the apparatus 504-1. The first apparatus 504-1 and the second apparatus 504-2 additionally perform the sample rate correction of sample rate converter 503 in receiver 500. In order to avoid settling problems when changing the sampling instant (i.e. when changing from a first set of coefficients to a different second set of coefficients for calculating the samples of the second digital signal), the first apparatus 504-1 and the second apparatus 504-2 are connected in parallel and operated time interleaved. Accordingly, one of the apparatuses may settle, while the other is active. Accordingly, settling problems may be avoid, which might arise since a settling transient of the first apparatus 504-1 or the second apparatus 504-2 may be longer than the duration of a cyclic prefix. Additionally, the receiver 600 comprises an optional channel filter 509, which is connected between the decimation module 502 and the apparatuses 504-1, 504-2.

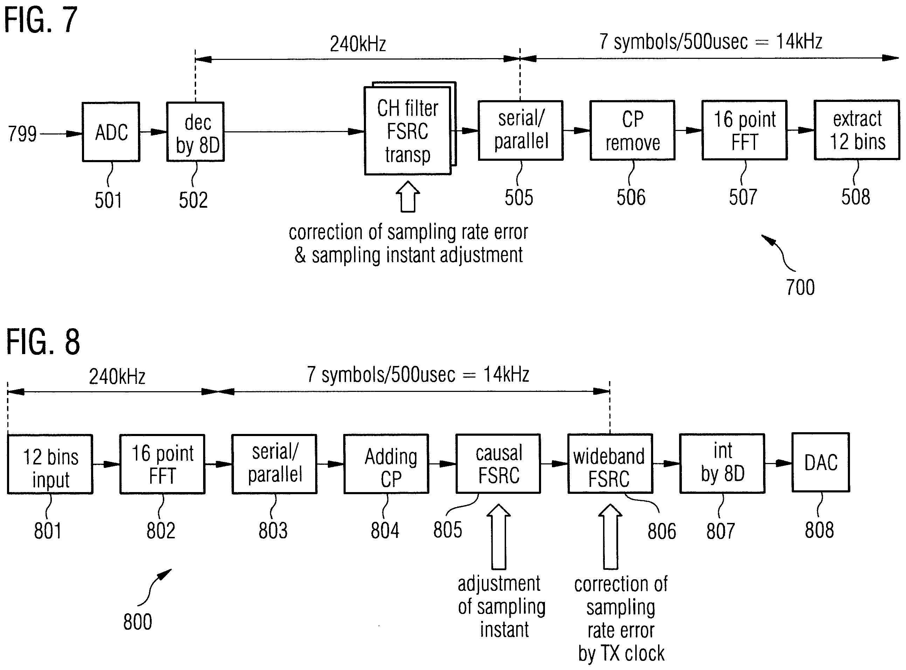

In summary, Fig. 7 illustrates a receiver comprising a decimation module 502 generating the first digital signal based on an output signal of the ADC 501 (the output signal having a third sample rate higher than the first sample rate), and a first apparatus 504-1 and a second apparatus 504-2 for generating a second digital signal based on a first digital signal according to one or more aspects of the proposed concept or one or more examples described above.

An alternative implementation avoiding the optional channel filter 509 is illustrated in Fig. 7. That is, the decimated output signal of the ADC is supplied directly to the apparatuses 504-1, 504-2.

Fig. 8 illustrates an example of a NB-LTE transmitter 800 comprising an apparatus for generating a second digital signal based on a first digital signal according to one or more aspects of the proposed concept or one or more examples described above.

A 12 bins of a LTE baseband transmit signal 801 are supplied to an iFFT module 802, which applies a 16 point inverse Fourier transformation and supplies the resulting signal to a serial to parallel converter 803. From the serial to parallel converter 803 the signal is provided a cyclic prefix addition module 804, which adds cyclic prefixes to the signal. The signal containing the symbols and the cyclic prefixes is then supplied as the first digital signal to an apparatus 805 for generating a second digital signal based on a first digital signal according to one or more aspects of the proposed concept or one or more examples described above. The apparatus 805 generates a second digital signal and adjusts the phases of one or more samples of the second digital signal according to a structure of the slot of a LTE baseband transmit signal, which is represented by the first digital signal, as described above. That is, the positions of the samples within the slot is adjusted to the requirements for the second digital signal. The second digital signal is the integrated by integration module 807 and provided to a digital-to-analog converter (DAC) 808. The resulting analog signal may then be provided to a transmission stage for up-conversion and transmission to the environment.

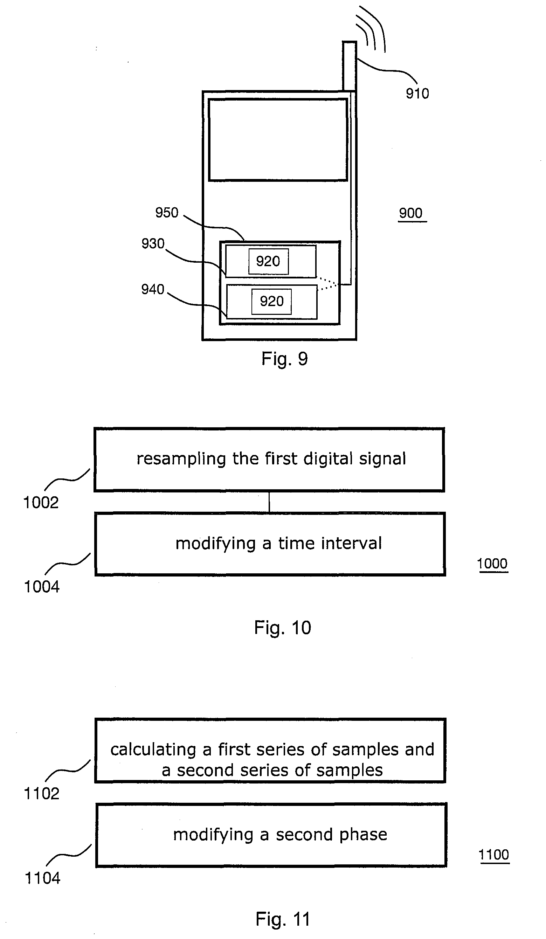

Another example of an implementation using an apparatus for generating a second digital signal based on a first digital signal according to one or more aspects of the proposed concept or one or more examples described above is illustrated in Fig. 9. Fig. 9 schematically illustrates an example of a mobile communications device or mobile phone or user equipment 900 comprising an apparatus 920 according to an example described herein. The apparatus 920 may be comprised by a receiver 930 (e.g. according to the example described herein), or a transmitter 940 (e.g. according to the example described herein). The receiver 930 and the transmitter 940 may be comprised by a transceiver 950. An antenna element 910 of the mobile communications device 900 may be coupled to the receiver 930, the transmitter 940, or the transceiver 950. To this end, mobile communications devices with reduced power consumption may be provided.

An example of a method 1000 for generating a second digital signal having a second sample rate based on a first digital signal having a first sample rate is illustrated by means of a flowchart in Fig. 10. The first digital signal represents a finite data sequence. The method 1000 comprises resampling 1002 the first digital signal at a compensated sample time as a sample of the second digital signal. Further, the method 1000 comprises modifying 1004 a time interval between a sample time of the first digital signal and the compensated sample time based on a structure of the finite data sequence.

More details and aspects of the method are mentioned in connection with the proposed concept or one or more examples described above (e.g. Figs. 1-3 and 5 to 9). The method may comprise one or more additional optional features corresponding to one or more aspects of the proposed concept or one or more examples described above.

An example of a method 1100 for generating a second digital signal based on a first digital signal having a first sample rate is illustrated by means of a flowchart in Fig. 11. The first digital signal represents a finite data sequence. The method 1100 comprises calculating 1102 a first series of samples of the second digital signal and a second series of samples of the second digital signal based on the first digital signal. The second series of samples directly succeeds the first series of samples, wherein succeeding samples within the first series of samples and succeeding samples within the second series of samples are separated by a first phase, respectively. Further, the method 1100 comprises modifying 1104 a second phase between a last sample of the first series of samples and a first sample of the second series of samples based on a structure of the finite data sequence, the second phase being different from the first phase.

More details and aspects of the method are mentioned in connection with the proposed concept or one or more examples described above (e.g. Figs. 4-9). The method may comprise one or more additional optional features corresponding to one or more aspects of the proposed concept or one or more examples described above.

The examples as described herein may be summarized as follows:
Example 1 is an apparatus for generating a second digital signal having a second sample rate based on a first digital signal having a first sample rate, the first digital signal representing a finite data sequence, the apparatus comprising a sample rate converter configured to resample the first digital signal at a compensated sample time as a sample of the second digital signal, wherein the sample rate converter is configured to modify a time interval between a sample time of the first digital signal and the compensated sample time based on a structure of the finite data sequence.
In example 2, the sample rate converter in the apparatus of example 1 is configured to set the time interval to the difference between the sample time of the first digital signal and the time instant of the beginning of an element of the data structure in the first digital signal.
In example 3, the sample rate converter in the apparatus of example 1 or example 2 comprises a plurality of sets of coefficients, wherein the sample rate converter is configured to calculate the sample of the second digital signal using one of the plurality of sets of coefficients, the one of the plurality of sets of coefficients being selected based on the structure of the finite data sequence.
In example 4, the one of the plurality of sets of coefficients in the apparatus of example 3 is further selected based on a comparison of the first sample rate and the second sample rate.
In example 5, the first sample rate is equal to the second sample rate in the apparatus of any of the preceding examples.
In example 6, the first digital signal in the apparatus of any of the preceding examples is related to a LTE receive signal, wherein the finite data sequence is the data comprised by a slot of the LTE receive signal.
In example 7, an element of the finite data sequence is a symbol within the slot in the apparatus of example 6.
In example 8, the second sample rate is lower than 1.92 MHz in the apparatus of example 6 or example 7.
In example 9, the second sample rate is 240 kHz in the apparatus of any of examples 6 to 8.
In example 10, the first digital signal in the apparatus of any of examples 1 to 5 is related to a LTE baseband transmit signal, wherein the finite data sequence is the data comprised by a slot of the LTE baseband transmit signal.
In example 11, an element of the finite data sequence is a symbol within the slot in the apparatus of example 10.
In example 12, the first sample rate is lower than 1.92 MHz in the apparatus of example 10 or example 11.
In example 13, the first sample rate is 240 kHz in the apparatus of any of examples 10 to 12.
Example 14 is an apparatus for generating a second digital signal based on a first digital signal having a first sample rate, the first digital signal representing a finite data sequence, the apparatus comprising a sample rate converter configured to calculate a first series of samples of the second digital signal and a second series of samples of the second digital signal based on the first digital signal, the second series of samples directly succeeding the first series of samples, wherein succeeding samples within the first series of samples and succeeding samples within the second series of samples are separated by a first phase, respectively, wherein the sample rate converter is configured to modify a second phase between a last sample of the first series of samples and a first sample of the second series of samples based on a structure of the finite data sequence, the second phase being different from the first phase.
In example 15, a time difference between the second phase and the first phase is an integer fraction of the first phase in the apparatus of example 14.
In example 16, the sample rate converter in the apparatus of example 14 or example 15 is configured to set the second phase to the difference between a duration of a first element of the finite data sequence and a time interval between the first and the last sample of the first series of samples.
In example 17, the sample rate converter in the apparatus of any of examples 14 to 16 comprises a plurality of sets of coefficients, and wherein the sample rate converter is configured to calculate the first series of samples of the second digital signal using a first set of the plurality of sets of coefficients and to calculate the second series of samples of the second digital signal using a different second set of the plurality of sets of coefficients, the first set and the second set being selected based on the structure of the finite data sequence.
In example 18, at least one of the first set and the second set in the apparatus of example 17 is further selected based on a comparison of the first sample rate and the first phase.
In example 19, the sample rate converter in the apparatus of any of examples 14 to 18 is configured to calculate a third series of samples of the second digital signal, the third series of samples directly succeeding the second series of samples, wherein succeeding samples within the third series of samples are separated by the first phase, respectively, and wherein the sample rate converter is configured to modify a third phase between a last sample of the second series of samples and a first sample of the third series of samples based on the structure of the finite data sequence, the third phase being different from the first phase.
In example 20, the sample rate converter in the apparatus of example 19 is configured to set the third phase to the difference between a duration of a second element of the finite data sequence and a time interval between the first and the last sample of the second series of samples, the second element directly succeeding the first element of the finite data sequence.
In example 21, the first sample rate corresponds to the first phase in the apparatus of any of examples 14 to 20.
In example 22, the first digital signal is related to a LTE receive signal in the apparatus of any of examples 14 to 21, wherein the finite data sequence is the data comprised by a slot of the LTE receive signal.
In example 23, a first element of the finite data sequence is a cyclic prefix, or a symbol and the succeeding cyclic prefix within the slot in the apparatus of example 22.
In example 24, the first phase is greater than 0.521 microseconds in the apparatus of example 22 or example 23.
In example 25, the first phase corresponds to a sample rate of 240 kHz in the apparatus of any of examples 22 to 24.
In example 26, the first digital signal is related to a LTE baseband transmit signal in the apparatus of any of examples 14 to 21, wherein the finite data sequence is the data comprised by a slot of the LTE baseband transmit signal.
In example 27, a first element of the finite data sequence is a cyclic prefix, or a symbol and the succeeding cyclic prefix within the slot in the apparatus of example 26.
In example 28, the first sample rate is lower than 1.92 MHz in the apparatus of example 26 or example 27.
In example 29, the first sample rate is 240 kHz in the apparatus of any of examples 26 to 28.
Example 30 is a receiver comprising an apparatus for generating a second digital signal according to any of examples 1 to 9, or an apparatus for generating a second digital signal according to any of examples 14 to 25.
In example 31, the receiver of example 30 further comprises a second sample rate converter configured to generate the first digital signal based on a decimated output signal of an analog-to-digital converter.
In example 32, the receiver of example 30 further comprises a decimation module configured to generate the first digital signal based on an output signal of an analog-to-digital converter, the output signal having a third sample rate higher than the first sample rate.
In example 33, the receiver of example 32 further comprises a second apparatus for generating a second digital signal according to any of examples 1 to 9 which is connected in parallel to the apparatus for generating a second digital signal according to any of examples 1 to 9, or a second apparatus for generating a second digital signal according to any of examples 14 to 25 which is connected in parallel to the apparatus for generating a second digital signal according to any of examples 14 to 25.
In example 34, the receiver of any of the preceding examples further comprises a baseband processing unit configured to receive the second digital signal.
Example 35 is a transmitter comprising an apparatus for generating a second digital signal according to any of examples 1 to 5 and 10 to 13, or an apparatus for generating a second digital signal according to any of examples 14 to 21 and 26 to 29.
In example 36, the transmitter of example 35 further comprises a baseband processing unit configured to generate the first digital signal.
In example 37, the transmitter of example 35 or example 36 further comprises a second sample rate converter configured to generate a third digital signal based on the second digital signal, an integration module configured to integrate the third digital signal, and a digital-to-analog converter configured to receive the integrated third digital signal.
Example 38 is a transceiver comprising a receiver according to any of examples 30 to 34, or a transmitter according to any of examples 35 to 37.
Example 39 is a mobile communications device comprising a receiver according to any of examples 30 to 34, a transmitter according to any of examples 35 to 37, or a transceiver according to example 38.
In example 40, the mobile communications device of example 39 further comprises at least one antenna coupled to the receiver, the transmitter, or the transceiver.
Example 41 is a means for generating a second digital signal having a second sample rate based on a first digital signal having a first sample rate, the first digital signal representing a finite data sequence, the means comprising a means for resampling the first digital signal at a compensated sample time as a sample of the second digital signal, wherein the means for resampling the first digital signal is configured to modify a time interval between a sample time of the first digital signal and the compensated sample time based on a structure of the finite data sequence.
In example 42, the means for resampling the first digital signal in the means of example 41 is configured to set the time interval to the difference between the sample time of the first digital signal and the time instant of the beginning of an element of the data structure in the first digital signal.
Example 43 is a means for generating a second digital signal based on a first digital signal having a first sample rate, the first digital signal representing a finite data sequence, the means comprising a means for calculating a first series of samples of the second digital signal and a second series of samples of the second digital signal based on the first digital signal, the second series of samples directly succeeding the first series of samples, wherein succeeding samples within the first series of samples and succeeding samples within the second series of samples are separated by a first phase, respectively, wherein the means for calculating is configured to modify a second phase between a last sample of the first series of samples and a first sample of the second series of samples based on a structure of the finite data sequence, the second phase being different from the first phase.
In example 44, the means for calculating in the means of example 43 is configured to set the second phase to the difference between a duration of a first element of the finite data sequence and a time interval between the first and the last sample of the first series of samples.
Example 45 is a method for generating a second digital signal having a second sample rate based on a first digital signal having a first sample rate, the first digital signal representing a finite data sequence, the method comprising resampling the first digital signal at a compensated sample time as a sample of the second digital signal, and modifying a time interval between a sample time of the first digital signal and the compensated sample time based on a structure of the finite data sequence.
In example 46, the time interval in the method of example 45 is set to the difference between the sample time of the first digital signal and the time instant of the beginning of an element of the data structure in the first digital signal.
In example 47, resampling the first digital signal at the compensated sample time in the method of example 45 or example 46 comprises calculating the sample of the second digital signal using one of a plurality of sets of coefficients, the one of the plurality of sets of coefficients being selected based on the structure of the finite data sequence.
In example 48, the one of the plurality of sets of coefficients in the method of example 47 is further selected based on a comparison of the first sample rate and the second sample rate.
In example 49, the first sample rate is equal to the second sample rate in the method of any of the preceding examples.
In example 50, the first digital signal is related to a LTE receive signal in the method of any of the preceding examples, wherein the finite data sequence is the data comprised by a slot of the LTE receive signal.
In example 51, an element of the finite data sequence is a symbol within the slot in the method of example 50.
In example 52, the second sample rate is lower than 1.92 MHz in the method of example 50 or example 51.
In example 53, the second sample rate is 240 kHz in the method of any of examples 50 to 52.
In example 54, the first digital signal is related to a LTE baseband transmit signal in the method of any of examples 45 to 49, wherein the finite data sequence is the data comprised by a slot of the LTE baseband transmit signal.
In example 55, an element of the finite data sequence is a symbol within the slot in the method of example 54.
In example 56, the first sample rate is lower than 1.92 MHz in the method of example 54 or example 55.
In example 57, the first sample rate is 240 kHz in the method of any of examples 54 to 56.
Example 58 is a method for generating a second digital signal based on a first digital signal having a first sample rate, the first digital signal representing a finite data sequence, the method comprising: calculating a first series of samples of the second digital signal and a second series of samples of the second digital signal based on the first digital signal, the second series of samples directly succeeding the first series of samples, wherein succeeding samples within the first series of samples and succeeding samples within the second series of samples are separated by a first phase, respectively; and modifying a second phase between a last sample of the first series of samples and a first sample of the second series of samples based on a structure of the finite data sequence, the second phase being different from the first phase.
In example 59, a time difference between the second phase and the first phase in the method of example 58 is an integer fraction of the first phase.
In example 60, the second phase in the method of example 58 or example 59 is set to the difference between a duration of a first element of the finite data sequence and a time interval between the first and the last sample of the first series of samples.
In example 61, a first set of a plurality of sets of coefficients is used for calculating the first series of samples of the second digital signal in the method of any of examples 58 to 60, and a different second set of the plurality of sets of coefficients is used for calculating the second series of samples of the second digital signal, the first set and the second set being selected based on the structure of the finite data sequence.
In example 62, at least one of the first set and the second set in the method of example 61 is further selected based on a comparison of the first sample rate and the first phase.
In example 63, the method of any of examples 58 to 62 further comprises: calculating a third series of samples of the second digital signal, the third series of samples directly succeeding the second series of samples, wherein succeeding samples within the third series of samples are separated by the first phase, respectively; and modifying a third phase between a last sample of the second series of samples and a first sample of the third series of samples based on the structure of the finite data sequence, the third phase being different from the first phase.
In example 64, the third phase in the method of example 63 is set to the difference between a duration of a second element of the finite data sequence and a time interval between the first and the last sample of the second series of samples, the second element directly succeeding the first element of the finite data sequence.
In example 65, the first sample rate corresponds to the first phase in the method of any of examples 58 to 64.
In example 66, the first digital signal is related to a LTE receive signal in the method of any of examples 58 to 65, wherein the finite data sequence is the data comprised by a slot of the LTE receive signal.
In example 67, a first element of the finite data sequence is a cyclic prefix, or a symbol and the succeeding cyclic prefix within the slot in the method of example 66.
In example 68, the first phase is greater than 0.521 microseconds in the method of example 66 or example 67.
In example 69, the first phase corresponds to a sample rate of 240 kHz in the method of any of examples 66 to 68.
In example 70, the first digital signal is related to a LTE baseband transmit signal in the method of any of examples 58 to 65, wherein the finite data sequence is the data comprised by a slot of the LTE baseband transmit signal.
In example 71, a first element of the finite data sequence is a cyclic prefix, or a symbol and the succeeding cyclic prefix within the slot in the method of example 70.
In example 72, the first sample rate is lower than 1.92 MHz in the method of example 70 or example 71.
In example 73, the first sample rate is 240 kHz in the method of any of examples 70 to 72.
Example 74 is a computer readable storage medium having stored thereon a program having a program code for performing the method of any of examples 45 to 73, when the program is executed on a computer or processor.
Example 75 is a computer program having a program code configured to perform the method of any of examples 45 to 73, when the computer program is executed on a computer or processor.

The aspects and features mentioned and described together with one or more of the previously detailed examples and figures, may as well be combined with one or more of the other examples in order to replace a like feature of the other example or in order to additionally introduce the feature to the other example.

Examples may further be a computer program having a program code for performing one or more of the above methods, when the computer program is executed on a computer or processor. Steps, operations or processes of various above-described methods may be performed by programmed computers or processors. Examples may also cover program storage devices such as digital data storage media, which are machine, processor or computer readable and encode machine-executable, processor-executable or computer-executable programs of instructions. The instructions perform or cause performing some or all of the acts of the above-described methods. The program storage devices may comprise or be, for instance, digital memories, magnetic storage media such as magnetic disks and magnetic tapes, hard drives, or optically readable digital data storage media. Further examples may also cover computers, processors or control units programmed to perform the acts of the above-described methods or (field) programmable logic arrays ((F)PLAs) or (field) programmable gate arrays ((F)PGAs), programmed to perform the acts of the above-described methods.

The description and drawings merely illustrate the principles of the disclosure. It will thus be appreciated that those skilled in the art will be able to devise various arrangements that, although not explicitly described or shown herein, embody the principles of the disclosure and are included within its spirit and scope. Furthermore, all examples recited herein are principally intended expressly to be only for pedagogical purposes to aid the reader in understanding the principles of the disclosure and the concepts contributed by the inventor(s) to furthering the art, and are to be construed as being without limitation to such specifically recited examples and conditions. Moreover, all statements herein reciting principles, aspects, and examples of the disclosure, as well as specific examples thereof, are intended to encompass equivalents thereof.

A functional block denoted as "means for ..." performing a certain function may refer to a circuit that is configured to perform a certain function. Hence, a "means for s.th." may be implemented as a "means configured to or suited for s.th.", such as a device or a circuit configured to or suited for the respective task.

Functions of various elements shown in the figures, including any functional blocks labeled as "means", "means for providing a sensor signal", "means for generating a transmit signal.", etc., may be implemented in the form of dedicated hardware, such as "a signal provider", "a signal processing unit", "a processor", "a controller", etc. as well as hardware capable of executing software in association with appropriate software. When provided by a processor, the functions may be provided by a single dedicated processor, by a single shared processor, or by a plurality of individual processors, some of which or all of which may be shared. However, the term "processor" or "controller" is by far not limited to hardware exclusively capable of executing software, but may include digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included.

A block diagram may, for instance, illustrate a high-level circuit diagram implementing the principles of the disclosure. Similarly, a flow chart, a flow diagram, a state transition diagram, a pseudo code, and the like may represent various processes, operations or steps, which may, for instance, be substantially represented in computer readable medium and so executed by a computer or processor, whether or not such computer or processor is explicitly shown. Methods disclosed in the specification or in the claims may be implemented by a device having means for performing each of the respective acts of these methods.

It is to be understood that the disclosure of multiple acts, processes, operations, steps or functions disclosed in the specification or claims may not be construed as to be within the specific order, unless explicitly or implicitly stated otherwise, for instance for technical reasons. Therefore, the disclosure of multiple acts or functions will not limit these to a particular order unless such acts or functions are not interchangeable for technical reasons. Furthermore, in some examples a single act, function, process, operation or step may include or may be broken into multiple sub-acts, -functions, -processes, -operations or -steps, respectively. Such sub acts may be included and part of the disclosure of this single act unless explicitly excluded.

The scope of protection is defined by the appended claims.

## Claims

1. An apparatus (100) for generating a second digital signal (112) having a second sample rate based on a first digital signal (111) having a first sample rate, the first digital signal (111) representing a finite data sequence, comprising:
a sample rate converter (110) configured to resample the first digital signal (111) at a second sample time as a sample of the second digital signal (112),
wherein the sample rate converter (110) is configured to modify a time interval between a first sample time of the first digital signal (111) and the second sample time based on a structure of the finite data sequence,
wherein the finite data sequence is known, so that the sample of the second digital signal is located at a desired position within the finite data sequence.

2. The apparatus of claim 1, wherein the sample rate converter (110) is configured to set the time interval to the difference between the first sample time of the first digital signal (111) and the time instant of the beginning of an element of the data structure in the first digital signal (111).

3. The apparatus of claim 1 or claim 2, wherein the sample rate converter (110) comprises a plurality of sets of coefficients, and wherein the sample rate converter is configured to calculate the sample of the second digital signal (112) using one of the plurality of sets of coefficients, the one of the plurality of sets of coefficients being selected based on the structure of the finite data sequence.

4. The apparatus of claim 3, wherein the one of the plurality of sets of coefficients is further selected based on a comparison of the first sample rate and the second sample rate.

5. The apparatus of any of the preceding claims, wherein the first sample rate is equal to the second sample rate.

6. The apparatus of any of the preceding claims, wherein the first digital signal (111) is related to a Long Term Evolution, LTE, receive signal, and wherein the finite data sequence is the data comprised by a slot of the LTE receive signal.

7. The apparatus of claim 6, wherein an element of the finite data sequence is a symbol within the slot.

8. The apparatus of claim 6 or claim 7, wherein the second sample rate is lower than 1.92 MHz.

9. The apparatus of any of claims 6 to 8, wherein the second sample rate is 240 kHz.

10. A receiver (930) comprising an apparatus for generating a second digital signal according to any of claims 1 to 9.

11. A method (1000) for generating a second digital signal having a second sample rate based on a first digital signal having a first sample rate, the first digital signal representing a finite data sequence, comprising:
resampling (1002) the first digital signal at a second sample time as a sample of the second digital signal; and
modifying (1004) a time interval between a first sample time of the first digital signal and the second sample time based on a structure of the finite data sequence,
wherein the finite data sequence is known, so that the sample of the second digital signal is located at a desired position within the finite data sequence.

12. The method of claim 11, wherein the time interval is set to the difference between the first sample time of the first digital signal and the time instant of the beginning of an element of the data structure in the first digital signal.

13. The method of claim 11 or claim 12, wherein resampling (1002) the first digital signal at the compensated sample time comprises calculating the sample of the second digital signal using one of a plurality of sets of coefficients, the one of the plurality of sets of coefficients being selected based on the structure of the finite data sequence.

14. The method of any of the preceding claims, wherein the first digital signal is related to a Long Term Evolution, LTE, receive signal, and wherein the finite data sequence is the data comprised by a slot of the LTE receive signal.

15. The method of claim 14, wherein an element of the finite data sequence is a symbol within the slot.

## Patentansprüche

1. Vorrichtung (100) zum Erzeugen eines zweiten digitalen Signals (112), das eine zweite Abtastrate aufweist, aufgrund eines ersten digitalen Signals (111), das eine erste Abtastrate aufweist, wobei das erste digitale Signal (111) eine endliche Datenfolge darstellt wobei die Vorrichtung umfasst:
einen Abtastratenwandler (110), der konfiguriert ist zum erneuten Abtasten des ersten digitalen Signals (111) zu einer zweiten Abtastzeit als eine Abtastung des zweiten digitalen Signals (112),
wobei der Abtastratenwandler (110) konfiguriert ist zum Verändern eines Zeitintervalls zwischen einer ersten Abtastzeit des ersten digitalen Signals (111) und einer zweiten Abtastzeit, aufgrund einer Struktur der endlichen Datenfolge, wobei die endliche Datenfolge bekannt ist, sodass die Abtastung des zweiten digitalen Signals an einer gewünschten Position innerhalb der endlichen Datenfolge angebracht wird.

2. Vorrichtung nach Anspruch 1, wobei der Abtastratenwandler (110) konfiguriert ist zum Einstellen des Zeitintervalls auf die Differenz zwischen der ersten Abtastzeit des ersten digitalen Signals (111) und dem Zeitpunkt des Beginns eines Elements der Datenstruktur in dem ersten digitalen Signal (111).

3. Vorrichtung nach Anspruch 1 oder Anspruch 2, wobei der Abtastratenwandler (110) eine Vielzahl von Koeffizientengruppen umfasst und wobei der Abtastratenwandler konfiguriert ist zum Berechnen der Abtastung des zweiten digitalen Signals (112) mithilfe von einer aus der Vielzahl von Koeffizientengruppen, wobei die eine aus der Vielzahl von Koeffizientengruppen aufgrund der Struktur der endlichen Datenfolge ausgewählt wird.

4. Vorrichtung nach Anspruch 3, wobei die eine aus der Vielzahl von Koeffizientengruppen außerdem aufgrund eines Vergleichs der ersten Abtastrate mit der zweiten Abtastrate ausgewählt wird.

5. Vorrichtung nach einem der vorhergehenden Ansprüche, wobei die erste Abtastrate gleich der zweiten Abtastrate ist.

6. Vorrichtung nach einem der vorhergehenden Ansprüche, wobei das erste digitale Signal (111) mit einem Long-Term-Evolution-Empfangssignal, LTE-Empfangssignal, in Beziehung steht, und wobei die endliche Datenfolge die Daten sind, die in einem Schlitz des LTE-Empfangssignals enthalten sind.

7. Vorrichtung nach Anspruch 6, wobei ein Element der endlichen Datenfolge ein Symbol innerhalb des Schlitzes ist.

8. Vorrichtung nach Anspruch 6 oder Anspruch 7, wobei die zweite Abtastrate niedriger als 1,92 MHz ist.

9. Vorrichtung nach einem der Ansprüche 6 bis 8, wobei die zweite Abtastrate 240 kHz beträgt.

10. Empfänger (930), der eine Vorrichtung zum Erzeugen eines zweiten digitalen Signals nach einem der Ansprüche 1 bis 9 umfasst.

11. Verfahren (1000) zum Erzeugen eines zweiten digitalen Signals, das eine zweite Abtastrate aufweist, aufgrund eines ersten digitalen Signals, das eine erste Abtastrate aufweist, wobei das erste digitale Signal eine endliche Datenfolge darstellt wobei das Verfahren umfasst:
erneutes Abtasten (1002) des ersten digitalen Signals zu einer zweiten Abtastzeit als eine Abtastung des zweiten digitalen Signals; und
Verändern (1004) eines Zeitintervalls zwischen einer ersten Abtastzeit des ersten digitalen Signals und einer zweiten Abtastzeit, aufgrund einer Struktur der endlichen Datenfolge, wobei die endliche Datenfolge bekannt ist, sodass die Abtastung des zweiten digitalen Signals an einer gewünschten Position innerhalb der endlichen Datenfolge angebracht wird.

12. Verfahren nach Anspruch 11, wobei das Zeitintervall auf die Differenz zwischen der ersten Abtastzeit des ersten digitalen Signals und dem Zeitpunkt des Beginns eines Elements der Datenstruktur in dem ersten digitalen Signal eingestellt wird.

13. Verfahren nach Anspruch 11 oder Anspruch 12, wobei das erneute Abtasten (1002) des ersten digitalen Signals zur kompensierten Abtastzeit ein Berechnen der Abtastung des zweiten digitalen Signals mithilfe einer Vielzahl von Koeffizientengruppen umfasst, wobei die eine aus der Vielzahl von Koeffizientengruppen aufgrund der Struktur der endlichen Datenfolge ausgewählt wird.

14. Verfahren nach einem der vorhergehenden Ansprüche, wobei das erste digitale Signal mit einem Long-Term-Evolution-Empfangssignal, LTE-Empfangssignal, in Beziehung steht, und wobei die endliche Datenfolge die Daten sind, die in einem Schlitz des LTE-Empfangssignals enthalten sind.

15. Verfahren nach Anspruch 14, wobei ein Element der endlichen Datenfolge ein Symbol innerhalb des Schlitzes ist.

## Revendications

1. Appareil (100) pour générer un deuxième signal numérique (112) ayant une deuxième fréquence d'échantillonnage sur la base d'un premier signal numérique (111) ayant une première fréquence d'échantillonnage, le premier signal numérique (111) représentant une séquence de données finie, comprenant :
un convertisseur de fréquence d'échantillonnage (110) configuré pour ré-échantillonner le premier signal numérique (111) à un deuxième instant d'échantillonnage comme un échantillon du deuxième signal numérique (112),
le convertisseur de fréquence d'échantillonnage (110) étant configuré pour modifier un intervalle de temps entre un premier instant d'échantillonnage du premier signal numérique (111) et le deuxième instant d'échantillonnage sur la base d'une structure de la séquence de données finie, la séquence de données finie étant connue, de sorte que l'échantillon du deuxième signal numérique se trouve à une position souhaitée à l'intérieur de la séquence de données finie.

2. Appareil selon la revendication 1, dans lequel le convertisseur de fréquence d'échantillonnage (110) est configuré pour régler l'intervalle de temps sur la différence entre le premier instant d'échantillonnage du premier signal numérique (111) et l'instant temporel du début d'un élément de la structure de données dans le premier signal numérique (111).

3. Appareil selon la revendication 1 ou 2, dans lequel le convertisseur de fréquence d'échantillonnage (110) comprend une pluralité d'ensembles de coefficients, et dans lequel le convertisseur de fréquence d'échantillonnage est configuré pour calculer l'échantillon du deuxième signal numérique (112) en utilisant un ensemble de coefficients de la pluralité d'ensembles de coefficients, ledit un ensemble de coefficients de la pluralité d'ensembles de coefficients étant sélectionné sur la base de la structure de la séquence de données finie.

4. Appareil selon la revendication 3, dans lequel ledit un ensemble de coefficients de la pluralité d'ensembles de coefficients est en outre sélectionné sur la base d'une comparaison de la première fréquence d'échantillonnage et de la deuxième fréquence d'échantillonnage.

5. Appareil selon l'une quelconque des revendications précédentes, dans lequel la première fréquence d'échantillonnage est égale à la deuxième fréquence d'échantillonnage.

6. Appareil selon l'une quelconque des revendications précédentes, dans lequel le premier signal numérique (111) est lié à un signal de réception de l'évolution à long terme, LTE, et dans lequel la séquence de données finie correspond aux données comprises dans un créneau du signal de réception LTE.

7. Appareil selon la revendication 6, dans lequel un élément de la séquence de données finie est un symbole à l'intérieur du créneau.

8. Appareil selon la revendication 6 ou 7, dans lequel la deuxième fréquence d'échantillonnage est inférieure à 1,92 MHz.

9. Appareil selon l'une quelconque des revendications 6 à 8, dans lequel la deuxième fréquence d'échantillonnage est de 240 kHz.

10. Récepteur (930) comprenant un appareil pour générer un deuxième signal numérique selon l'une quelconque des revendications 1 à 9.

11. Procédé (1000) pour générer un deuxième signal numérique ayant une deuxième fréquence d'échantillonnage sur la base d'un premier signal numérique ayant une première fréquence d'échantillonnage, le premier signal numérique représentant une séquence de données finie, comprenant les étapes consistant à :
ré-échantillonner (1002) le premier signal numérique à un deuxième instant d'échantillonnage comme un échantillon du deuxième signal numérique ; et
modifier (1004) un intervalle de temps entre un premier instant d'échantillonnage du premier signal numérique et le deuxième instant d'échantillonnage sur la base d'une structure de la séquence de données finie, la séquence de données finie étant connue, de sorte que l'échantillon du deuxième signal numérique se trouve à une position souhaitée à l'intérieur de la séquence de données finie.

12. Procédé selon la revendication 11, dans lequel l'intervalle de temps est réglé sur la différence entre le premier instant d'échantillonnage du premier signal numérique et l'instant temporel du début d'un élément de la structure de données dans le premier signal numérique.

13. Procédé selon la revendication 11 ou 12, dans lequel le ré-échantillonnage (1002) du premier signal numérique à l'instant d'échantillonnage compensé comprend le calcul de l'échantillon du deuxième signal numérique en utilisant un ensemble de coefficients d'une pluralité d'ensembles de coefficients, ledit un ensemble de coefficients de la pluralité d'ensembles de coefficients étant sélectionné sur la base de la structure de la séquence de données finie.

14. Procédé selon l'une quelconque des revendications précédentes, dans lequel le premier signal numérique est lié à un signal de réception de l'évolution à long terme, LTE, et dans lequel la séquence de données finie correspond aux données comprises dans un créneau du signal de réception LTE.

15. Procédé selon la revendication 14, dans lequel un élément de la séquence de données finie est un symbole à l'intérieur du créneau.
